# EUROPEAN PATENT APPLICATION

(11) **EP 4 770 266 A1**
(43) Date of publication of application: **01.07.2026**
(21) Application number: 25227651.4
(22) Date of filing: 30.12.2025
(51) Int. Cl.: H04W 84/18, H04W 4/38

(54) **SYSTEMS AND METHODS FOR MANAGING SENSOR ASSIGNMENTS IN THERMAL MANAGEMENT SYSTEMS**

(30) Priority: 31.12.2024 US 202463740500 P; 29.12.2025 US 202519434537
(71) Applicant: Vertiv Corporation, Westerville, OH 43082 (US)
(72) Inventor: KELLER, Matthew Griffith, Westerville, 43082 (US); WILSON, Michael, Westerville, 43082 (US); SPATZ, Mark Andrew, Westerville, 43082 (US)
(74) Representative: Ambroz, Simon

(57) **Abstract**

Systems and methods for managing sensor assignments in a thermal management system. In embodiments, a sensor network includes a plurality of sensors and a plurality of gateway devices, and managing sensor assignments includes assigning sensors to gateways based on sensor location in a coverage area, reassigning moved sensors to new gateway devices, and disconnecting sensors from previously assigned gateway devices to eliminate conflicting reports and erroneous sensor alters and alarms. In embodiments, managing sensor assignments includes polling gateway devices to identify dormant sensors and disconnecting dormant sensors from gateway devices. The system and methods may be implemented in a data center environment.

## Description

### CROSS REFERENCE TO RELATED APPLICATION

This application claims the benefit of priority of U.S. Application Number 63/740,500 filed December 31, 2024.

### TECHNICAL FIELD

The present disclosure relates generally to sensor-based monitoring systems, and more particularly, to managing sensor assignments in thermal management systems.

### BACKGROUND

Data centers house high performance electronic equipment that must be thermally protected to ensure proper and efficient operation. Thermal protection is typically achieved using complex cooling systems that must be carefully monitored. As data centers scale up, there is a need for software for executing critical tasks such as monitoring and managing thermal conditions, auto-discovering devices, optimizing energy use, etc. In use, traditional thermal management systems aggregate data from connected devices to ensure optimal thermal conditions and performance.

Data centers may utilize sensor networks to gather information throughout the environment. Traditional sensor networks include a plurality of sensors in communication with a base station or 'gateway' device. In use, each sensor is positioned in the environment and configured to gather and report environmental data to its respective gateway for further handling. As data centers scale up, so does the number of sensors needed to monitor the environment. For example, large scale data centers may require hundreds if not thousands of sensors.

There are practical limitations on the number of sensors that can be communicatively coupled to a single gateway, as well as range limitations in the case of wireless sensor connectivity. As such, expansive sensor networks may require multiple gateways to handle the vast amount of sensor data. In addition, as data centers grow, add, remove, and/or reposition electronic equipment and structures, it may be necessary to reassign sensors to a different existing gateway or to a new gateway added to the network. In some instances, a user may be delayed or altogether forget to remove a sensor from an old gateway, thereby creating conflicting reports and/or nuisance alerts and alarms.

Therefore, what is needed is a solution for managing sensor assignments in a high-density sensor network.

### SUMMARY

According to one aspect, the present disclosure is directed to a system for monitoring a data center environment. In embodiments, the system includes a plurality of sensors configured to monitor environmental conditions in the data center, a plurality of gateway devices in communication with the plurality of sensors and configured to receive data from the plurality of sensors, and a controller in communication with the plurality of gateway devices and including one or more processors configured to implement a sensor assignment scheme. In embodiments, the sensor assignment scheme includes receiving a self-identifying code from each sensor, assigning each sensor to a gateway device corresponding to a current sensor location and upon moving a sensor to a new location, reassigning the moved sensor to a different gateway device corresponding to the new sensor location and disconnecting the moved sensor from any previously assigned gateway device.

In some embodiments, the sensor assignment scheme further includes polling the plurality of gateway devices to determine any sensors operating in a dormant state, and disconnecting any sensors determined to be operating in the dormant state from the plurality of gateway devices.

In some embodiments, the dormant state corresponds to a time period of reporting inactivity exceeding a predetermined time period.

In some embodiments, the plurality of sensors are grouped into subsets of sensors, and wherein each subset of sensors is configured to monitor a predetermined coverage area in the data center.

In some embodiments, each gateway device is assigned to a different coverage area in the data center.

In some embodiments, each sensor is assigned to one of the plurality of gateway devices based on a physical location in the data center.

In some embodiments, the controller includes a display interface configured to monitor and manage sensor assignments.

In some embodiments, the system is configured to be implemented in conjunction with a cooling system in the data center.

According to another aspect, the present disclosure is directed to a controller for controlling sensor assignments in a thermal management system including a plurality of sensors and a plurality of gateways devices. In embodiments, the controller includes one or more processors configured to receive a self-identifying code from each sensor, assign each sensor based on a current sensor location to a gateway device assigned to the current sensor location, and upon moving a sensor to a new location, reassigning the moved sensor to a different gateway device assigned to the new sensor location and disconnecting the moved sensor from a previously assigned gateway device.

In some embodiments, the controller is further configured to poll the plurality of gateway devices to identify sensors operating in a dormant state and disconnect any sensors operating in a dormant state from the plurality of gateway devices.

According to a further aspect, the present disclosure is directed to a method for managing sensor assignments in a thermal management system, the method including steps performed by a controller including one or more processors, the method including receiving self-identifying codes from a plurality of sensors in a sensor network, assigning the plurality of sensors to a gateway device assigned to a current sensor location in a coverage area, and upon moving a sensor to a new sensor location in the coverage area, reassigning the moved sensor to a new gateway device assigned to the new sensor location and disconnecting the moved sensor from a previously assigned gateway device.

In some embodiments, the method further includes polling gateway devices to determine any sensors operating in a dormant state, and disconnecting any sensors determined to be operating in the dormant state from the gateway devices.

This summary is provided solely as an introduction to subject matter that is fully described in the following detailed description and drawing figures. This summary should not be considered to describe essential features nor be used to determine the scope of the claims. Moreover, it is to be understood that both the foregoing summary and the following detailed description are explanatory only and are not necessarily restrictive of the subject matter claimed.

### BRIEF DESCRIPTION OF THE DRAWINGS

Implementations of the present disclosure disclosed herein may be better understood when consideration is given to the following detailed description thereof. Such description refers to the included drawings, which are not necessarily to scale, and in which some features may be exaggerated and some features may be omitted or may be represented schematically in the interest of clarity. Like reference numerals in the drawings may represent and refer to the same or similar element, feature, or function. In the drawings:
FIG. 1A is a schematic diagram of a sensor network for monitoring environmental conditions in a data center, in accordance with an example embodiment of the present disclosure;
FIG. 1B is a schematic diagram of the sensor network illustrating sensor reassignments for moved sensors, in accordance with an example embodiment of the present disclosure;
FIG. 1C is a schematic diagram of the sensor network illustrating sensor reassignments to a new gateway device, in accordance with an example embodiment of the present disclosure;
FIG. 2 is a table illustrating sensor assignment management in a thermal management system; in accordance with an example embodiment of the present disclosure; and
FIG. 3 is a flow diagram illustrating a methodology for managing sensor assignments in a sensor network, in accordance with an example embodiment of the present disclosure.

### DETAILED DESCRIPTION

Before explaining one or more embodiments of the disclosure in detail, it is to be understood that the embodiments are not limited in their application to the details of construction and the arrangement of the components or steps or methodologies set forth in the following description or illustrated in the drawings. In the following detailed description of embodiments, numerous specific details may be set forth in order to provide a more thorough understanding of the disclosure. However, it will be apparent to one of ordinary skill in the art having the benefit of the instant disclosure that the embodiments disclosed herein may be practiced without some of these specific details. In other instances, well-known features may not be described in detail to avoid unnecessarily complicating the instant disclosure.

As used herein a letter following a reference numeral is intended to reference an embodiment of the feature or element that may be similar, but not necessarily identical, to a previously described element or feature bearing the same reference numeral (e.g., 1, 1a, 1b). Such shorthand notations are used for purposes of convenience only and should not be construed to limit the disclosure in any way unless expressly stated to the contrary.

Further, unless expressly stated to the contrary, "or" refers to an inclusive or and not to an exclusive or. For example, a condition A or B is satisfied by any one of the following: A is true (or present), and B is false (or not present), A is false (or not present) and B is true (or present), and both A and B are true (or present).

In addition, the use of "a" or "an" may be employed to describe elements and components of embodiments disclosed herein. This is done merely for convenience and "a" and "an" are intended to include "one" or "at least one," and the singular also includes the plural unless it is obvious that it is meant otherwise.

Finally, as used herein any reference to "one embodiment" or "embodiments" means that a particular element, feature, structure, or characteristic described in connection with the embodiment is included in at least one embodiment disclosed herein. The appearances of the phrase "in embodiments" in various places in the specification are not necessarily all referring to the same embodiment, and embodiments may include one or more of the features expressly described or inherently present herein, or any combination or sub-combination of two or more such features, along with any other features which may not necessarily be expressly described or inherently present in the instant disclosure.

Broadly, the present disclosure is directed to data centers, cooling system applications, thermal management systems, sensor networks, and sensor management. More particularly, the present disclosure is directed to systems and methods for managing sensor assignments in a sensor network such as a high-density sensor network in a data center. In embodiments, sensor assignments to gateway devices are managed such that each sensor reports to a currently assigned gateway device and does not report to any previously assigned gateway device. In some embodiments, sensor reassignment to a new gateway device may automatically disconnect the sensor from a previously assigned gateway device, and dormant sensors may be disconnected from gateway devices such that conflicting reporting and erroneous alarms can be removed from the sensor network. Advantages of the systems and methods disclosed herein include, but are not limited to, minimizing or avoiding the loss of critical data, integration with thermal management systems, enhanced control, scalability, and energy and costs savings.

In embodiments, a sensor network according to the present disclosure generally includes a plurality of sensors, a plurality of gateway devices in communication with the plurality of sensors, and a controller in communication with at least the plurality of gateway devices. Each sensor may be configured to monitor at least one environmental parameter (e.g., temperature, humidity, etc.). Sensors may be grouped according to subsets, for example, with each subset assigned to a predetermined coverage area. Sensors may be wired or wireless. In the case of wireless sensors, communications may be established via conventional protocols such Wi-Fi (e.g., 802.11 family of wireless networking protocols), Bluetooth, Zigbee, Z-Wave, CDMA, TDMA, infrared, etc.

In embodiments, each gateway device may communicate with its associated subset of sensors according to a polling scheme in which the gateway device is configured to poll the sensors according to a predetermined recurring sequence to obtain data collected by the sensors. In embodiments, a controller in communication with or part of a thermal management system may communicate with multiple gateways via a polling scheme in which the controller is configured to poll the gateways according to a predetermined recurring sequence to obtain data collected by the gateways.

In embodiments, a controller as described herein may include one or more processors and a memory device, or memory. For example, the one or more processors may be configured to execute a set of program instructions maintained in the memory device. The one or more processors may include any processor or processing element known in the art. For the purposes of the present disclosure, the term "processor" or "processing element" may be broadly defined to encompass any device having one or more processing or logic elements (e.g., one or more micro-processor devices, one or more application specific integrated circuit (ASIC) devices, one or more field programmable gate arrays (FPGAs), or one or more digital signal processors (DSPs)). In this sense, the one or more processors may include any device configured to execute algorithms and/or instructions (e.g., program instructions stored in memory). Moreover, different subsystems of the present disclosure may include a processor or logic elements suitable for carrying out at least a portion of the steps described herein. Further, the steps described herein may be carried out by a single controller or, alternatively, multiple controllers. Further, the controller may analyze or otherwise process data received from the sensors and feed the data to additional components or external to the system.

The memory device may include any storage medium known in the art suitable for storing program instructions executable by the associated one or more processors. For example, the memory device may include a non-transitory memory medium. As an additional example, the memory device may include, but is not limited to, a read-only memory, a random-access memory, a magnetic or optical memory device (e.g., disk), a magnetic tape, a solid-state drive and the like. It is further noted that the memory device may be housed in a common controller housing with the one or more processors.

In embodiments, the controller may be embodied in or communicatively coupled to a display interface configured to display information pertaining to the thermal management system. In embodiments, the display interface may be a touchscreen configured to navigate screens and input information and changes. In some embodiments, the display interface may be coupled to one or more peripheral devices.

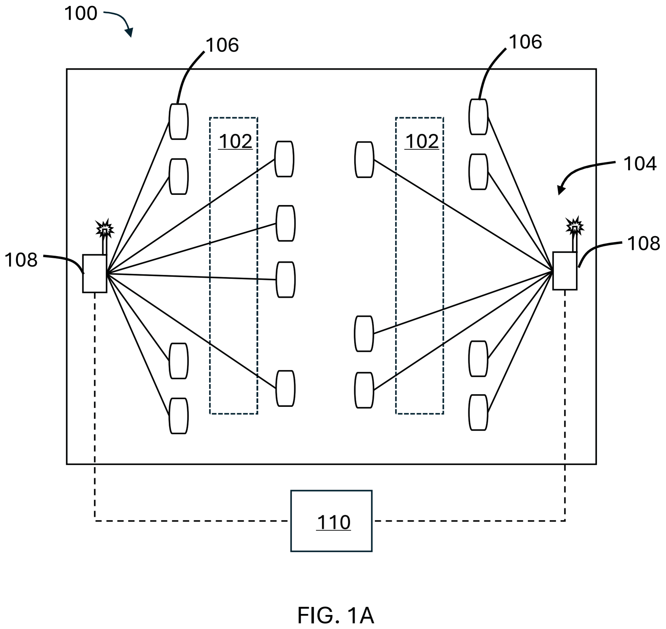

FIGS. 1A-C schematically illustrate a non-limiting example of a data center 100 including electronic equipment mounted in, for example, racks 102. The data center may include one or more of liquid and air-cooling systems for room cooling, in-row cooling, rack cooling, contact cooling, etc. The data center 100 further includes a sensor network 104, for instance a wireless sensor network, including a plurality of sensors 106 distributed throughout the environment to be monitored. In use, each sensor 106 can be configured to detect an environmental parameter (e.g., temperature, humidity, etc.) and/or electrical parameter (e.g., power, current, voltage, etc.), collect data, and convey the collected data to at least one gateway device 108 in communication with at least one controller 110 that is part of or in communication with a thermal management system.

FIG. 1A illustrates a sensor network including first and second gateway devices 108 in communication with assigned sensors 106 and the controller 110. For example, the gateway device 108 shown on the left side of the figure may represent a first gateway device 108 assigned to cover a first coverage area, and the second gateway device 108 shown on the right side of the figure may represent a second coverage area. The first and second coverage areas may or may not overlap, and the sensor network may include more gateway devices and sensors than shown. Each coverage area includes a plurality of sensors 106 for sensing environmental conditions in their respective coverage area. As shown, each sensor 106 in the first coverage area is in communication with the gateway device 108 assigned to the first coverage area. Likewise, each sensor 106 in the second coverage area is in communication with the gateway device 108 assigned to the second coverage area. The sensors 106 may be grouped into subsets of sensors such as the groupings shown.

Each sensor 106 and gateway device 108 may be wired or wireless-equipped to communicate with at least one other sensor and at least one other gateway within the network, respectively. Each sensor 106 may be positioned to monitor the environment or equipment positioned in the environment, such as electronic equipment or cooling system equipment. Each gateway device 108 may be positioned in the data center or in a remote location depending on the communication capabilities of the sensors and gateways. The controller 110 may be located on-site in the data center 100 or remote. In embodiments, the controller 110 is part of a thermal management system including hardware and software capabilities configured to monitor, alert, implement changes, recognize devices, program, etc. In other words, the thermal management system may be a comprehensive cooling system management system.

Each subset of sensors 106 and their respective gateway device 108 may include any number of sensors and topology. For example, the topology may include a configuration in which the gateway device 108 is configured to send and receive wireless signals to each of the connected sensors 106 in its respective subset, or a topology in which the connected sensors 106 may be further configured to communicate with each other to forward data depending on the transmission range and location of the sensors 106. For example, a sensor 106 positioned at a distance from its assigned gateway 108 may relay data to another sensor 106 within range of the assigned gateway 108. In this configuration, relay capabilities can be used to expand the coverage area.

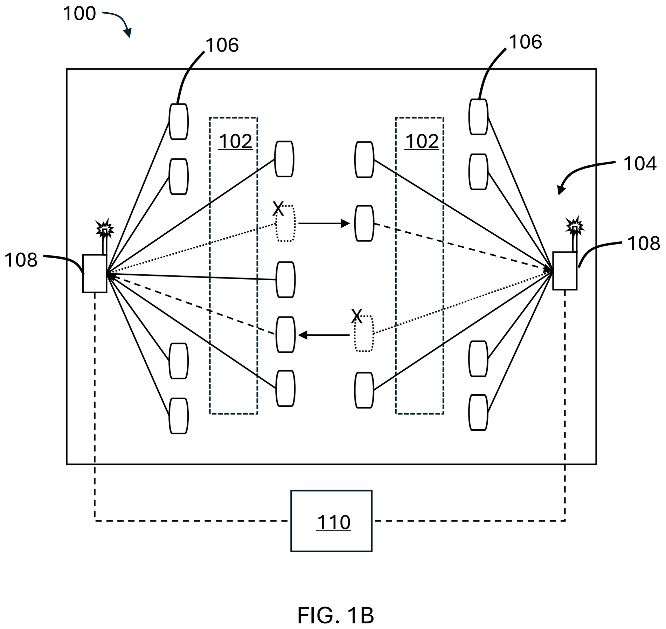

FIG. 1B illustrates sensor movement between the coverage areas in the data center 100. To explain sensor reassignment according to the present disclosure, one sensor 106 in the first coverage area (e.g., left side) is shown physically moved to the second coverage area (e.g., right side), and one sensor 106 in the second coverage area (e.g., right side) is shown physically moved to the first coverage area (e.g., left side). In other words, sensors 106 may be moved between existing coverage areas and gateway devices 108. The sensor 106 moved to the second coverage area now falls under the coverage of the gateway device 108 (e.g., right side) assigned to the second coverage area, whereas the sensor 106 moved to the first coverage area now falls under the coverage of the gateway device 108 (e.g., left side) assigned to the first coverage area. The assignments of the various gateway devices 108 may be based on communication range of the gateway devices 108, number of networks sensors, desired sensor groupings, type of electronic equipment, etc.

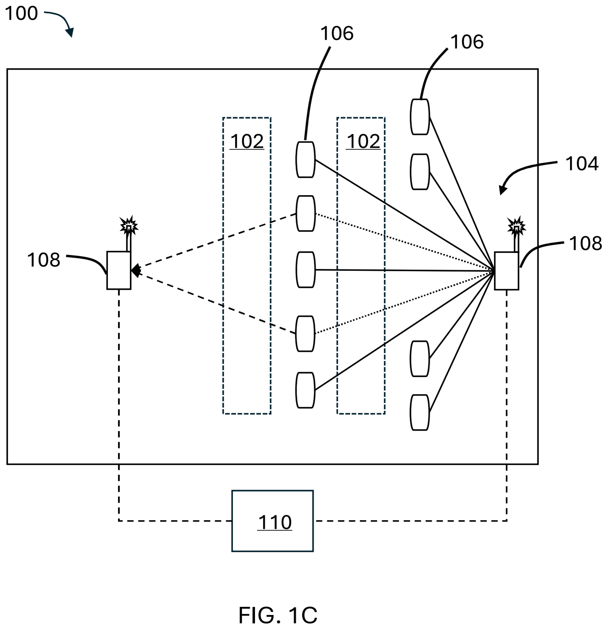

FIG. 1C illustrates sensor movement from an existing coverage area and gateway device 108 (e.g., right side), to a new gateway device 108 (e.g., left side). The sensors 106 reassigned to the new gateway device 108 may or may not be physically moved. After reassignment, the two sensors 106 shown now fall under the coverage area of the new gateway device 108 (e.g., left side).

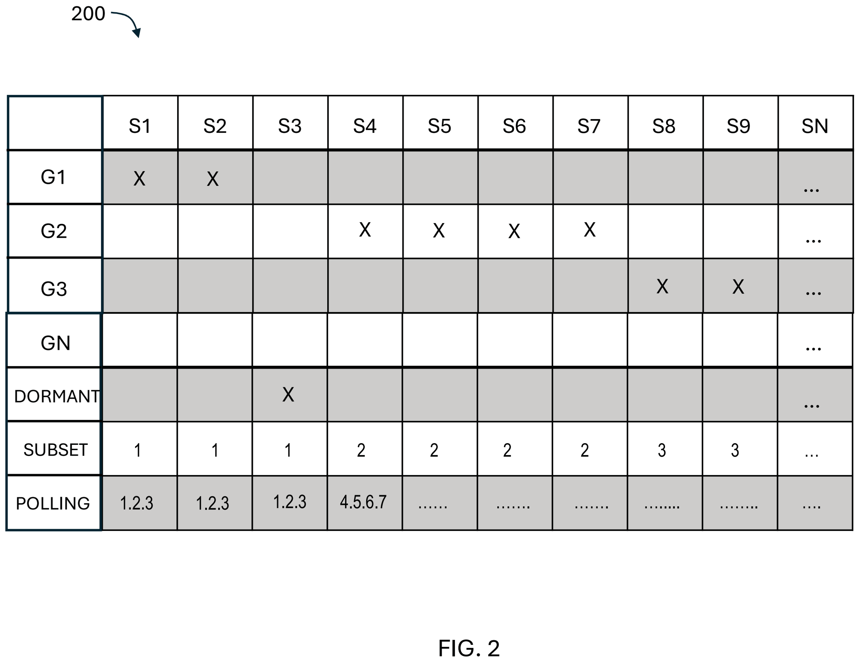

FIG. 2 illustrates a table 200 for managing sensor assignments, implemented and executed by the controller 110, in accordance with an example embodiment of the present disclosure. In embodiments, the table includes each sensor (S1, S2...SN) (individually or grouped into subsets) and the gateway devices (G1, G2...GN) present in the sensor network 104. Each sensor (S1, S2...SN) and gateway device (G1, G2...GN) may be identified by a self-identifying code (e.g., Sensor ID, MAC ID, or other value). In embodiments, the table 200 may further include a dormant assignment for sensors that have been identified and determined to be in a dormant state. For example, the controller 110 may be configured to poll the gateway devices (G1, G2...GN) and scan for sensors that have not reported to any gateway device within a predetermined time period. Sensors may be dormant because of malfunction, dead battery, loss of communication with gateway device, etc. In some embodiments, a sensor in the network not yet assigned to any gateway device may be assignment as dormant.

For example, sensors S1, S2 and S3 are shown as being included in sensor subset 1 and assigned to gateway device G1 for reporting. Sensor S3 is shown as being assignment dormant considering S3 has not reported to G1 within the predetermined time period (or multiple polling periods) required to be considered an 'active' sensor. A dormant assignment may cause the controller 110 to issue a maintenance alert. Sensors S4, S5, S6 and S7 are shown as being included in sensor subset 2 and assigned to gateway G2. For example, sensor S7 may have been previously assigned to gateway device G3 but has been reassigned to gateway device G2, leaving sensors S8 and S9 in a grouping of two sensors assigned to sensor subset 3 and reporting to gateway device G3.

In embodiments, sensors 106 may be polled according to a predetermined polling scheme. For example, each gateway device 108 may be configured to poll its assigned sensors 106 according to a predetermined polling protocol. In embodiments, the polling protocol may be predetermined and programmable via the controller 100 via the display interface. In embodiments, the polling protocol may be time-based wherein each sensor 106 is assigned a time interval, that may or may not be consistent in length depending on at least one of the capabilities of the sensor, latency, environmental parameter to be monitored, sensor hierarchy, etc. Each sensor 106 may be assigned a predetermined time interval to be polled and the time intervals may be organized to form a polling schedule. The schedule may include any recurring order depending on the hierarchy (e.g., importance) of a particular sensor and/or coverage area. When polled, each sensor 106 transmits collected data to its assigned gateway device 108. The collected data may include, but is not limited to, environmental parameter data, alarm data, sensor performance data, battery power data, etc. In the case of alarm data, each sensor 106 may be configured to transmit data to its assigned gateway device 108 outside of the assigned polling schedule to reduce latency of the reporting.

Each gateway device 108 may also be assigned a time interval according to a polling schedule. For example, as shown in FIG. 2, the first gateway G1 in communication with the first subset of sensors 1 including active sensors S1 and S2 may be assigned a first polling interval, the second gateway G2 in communication with the second subset of sensors 2 including sensors S4, S5, S6 and S7 may be assigned a second polling interval, and so on and so forth. The time intervals may be consistent or may vary according to a hierarchy. For example, a gateway in communication with a comparatively large number of sensors may be assigned a time interval longer in duration than a gateway in communication with a comparatively small number of sensors. Time intervals may also vary depending on disposition, latency, importance, etc.

In some embodiments, the scheduling may be dynamic in terms of assigning time intervals, scheduling time slots, modifications thereto, etc. In that regard, a particular gateway device may be assigned to one or more time slots in the schedule according to a hierarchy, and time slots may be added and adjusted as the sensor network is scaled up and scaled down in terms of the number of gateway devices, sensors, etc.

In use, each gateway device 108 may be configured to poll its respective subset of sensors according to the predetermined sensor polling schedule, and the controller 110 of the thermal management system is configured to poll each gateway device 108 according to the predetermined gateway polling schedule, thereby providing a dynamic polling scheme. In embodiments, the dynamic polling scheme may be programmable in terms of assigned time intervals, scheduled time slots, hourly schedules, daily schedules, peak energy use times, etc. In embodiments, the controller 110 of the thermal management system may be configured to poll any gateway device 108 on demand, for instance in response to receipt of alarm data.

In embodiments, polling may include paging a gateway device 108 thereby causing the gateway device 108 to send collected data or causing the assigned sensors 106 to send collected data via the respective gateway device 108. In that regard, the gateway devices 108 may function as data collectors including a memory for storing data, or a relay between the assigned sensors 106 and the controller 110. As mentioned above, collected data may include, but is not limited to, environmental data and sensor performance data. Data may take the form of binary or other data types.

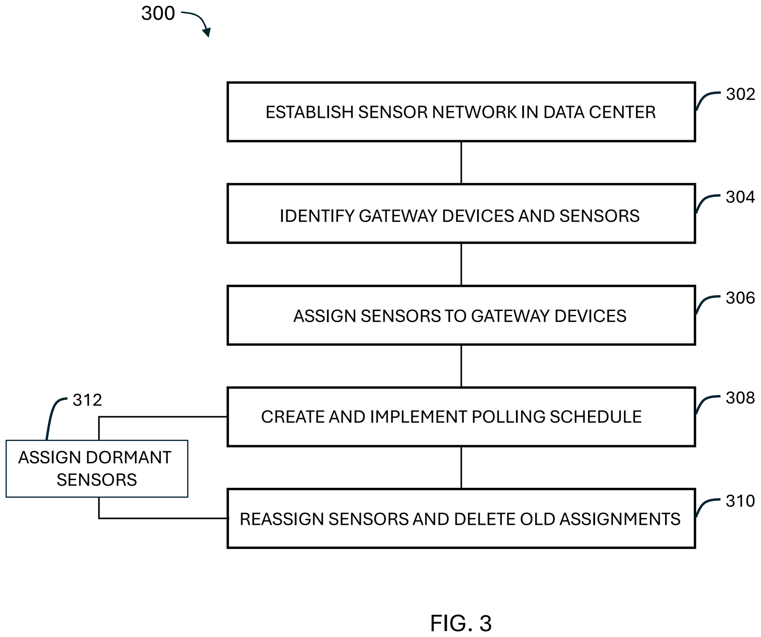

FIG. 3 is a flow chart illustrating a methodology 300 for managing sensor assignments in the sensor network 104. In a step 302, a sensor network is established in an environment, for instance a data center. In a step 304, each gateway device 108 and each sensor 106 is made known to the controller 110, for instance by a self-identifying code. In a step 306, each sensor 106 is assigned to a gateway device 108 based, for example, on a current physical location in a coverage area assigned to a respective one of the gateway devices 108. In other words, the current sensor location may determine the assignment to a particular coverage area assigned to a particular gateway device 108. In a step 308, based on the monitoring needs of the environment, scale of the monitoring system, gateway/sensor hierarchy, etc., the controller 110 is used to create a polling schedule for the gateway devices 108 and polls the respective gateway devices 108 according to the schedule to cause the gateways to return collected data.

In a step 310, when a sensor 106 is moved in the network or assigned to a new gateway device 108, the controller 110 is used to reassign the moved sensor 106 to a different gateway device 108 corresponding to the new sensor location and disconnect the moved sensor 106 from the previously assigned gateway device 108. Thus, when assigned to a gateway device 108, the sensor 106 is not in communication with any other gateway device 108. Likewise, when reassigned to a different or new gateway device 108, the reassigned sensor 106 does not report to the previously assigned gateway device 108. In a step 312, which may be implemented at any time during polling, the controller 110 may be used to assign sensors that are no longer reporting to a dormant state not associated with any gateway device 108. As sensors 106 become active they once again be assigned and reassigned as appropriate.

In embodiments, the controller 110 may be used to add, remove, identify, assign, reassign, etc. In some embodiments, the controller may be configured to 110 determined a current location of a sensor 106 and automatically assign the sensor 106 to the respective gateway device 108 assigned the coverage area corresponding to the current sensor location. In some embodiments, the controller 110 may be configured to automatically disconnect (e.g., break communication) a previously assigned gateway device 108 when a sensor 106 is reassigned.

From the above description, it is clear that the present disclosure disclosed herein is well adapted to achieve the objectives and to attain the advantages mentioned herein as well as those inherent in the present disclosure disclosed herein. While exemplary embodiments of the present disclosure disclosed herein have been described for purposes of this disclosure, it will be understood that numerous changes may be made which will readily suggest themselves to those skilled in the art and which are accomplished within the broad scope and coverage of the present disclosure disclosed and claimed herein.
Described herein are also the following clauses:
1. A system for monitoring a data center environment, the system comprising: a plurality of sensors configured to monitor environmental conditions in a data center; a plurality of gateway devices in communication with the plurality of sensors, the plurality of gateway devices configured to receive data from the plurality of sensors; and a controller in communication with the plurality of gateway devices, the controller including one or more processors configured to implement a sensor assignment scheme comprising: receiving a self-identifying code from each sensor; assigning each sensor to a gateway device corresponding to a current sensor location; and upon moving a sensor to a new location, reassigning a moved sensor to a different gateway device corresponding to the new sensor location and disconnecting the moved sensor from any previously assigned gateway device.
2. The system of clause 1, wherein the sensor assignment scheme further comprises: polling the plurality of gateway devices to determine any sensors operating in a dormant state; and disconnecting any sensors determined to be operating in the dormant state from the plurality of gateway devices.
3. The system of clause 2, wherein the dormant state corresponds to a time period of reporting inactivity exceeding a predetermined time period.
4. The system of clause 1, wherein the plurality of sensors are grouped into subsets of sensors, and wherein each subset of sensors is configured to monitor a predetermined coverage area in the data center.
5. The system of clause 1, wherein each gateway device is assigned to a different coverage area in the data center.
6. The system of clause 1, wherein each sensor is assigned to one of the plurality of gateway devices based on a physical location in the data center.
7. The system of clause 1, wherein the controller comprises a display interface configured to monitor and manage sensor assignments.
8. The system of clause 1, wherein the system is configured to be implemented in conjunction with a cooling system in the data center.
9. A controller for controlling sensor assignments in a thermal management system including a plurality of sensors and a plurality of gateways devices, the controller including one or more processors configured to: receive a self-identifying code from each sensor; assign each sensor, based on a current sensor location, to a gateway device assigned to the current sensor location; and upon moving a sensor to a new location, reassigning a moved sensor to a different gateway device assigned to the new sensor location and disconnecting the moved sensor from a previously assigned gateway device.
10. The controller of clause 9, further configured to: poll the plurality of gateway devices to determine any sensors operating in a dormant state; and disconnect any sensors determined to be operating in the dormant state from the plurality of gateway devices.
11. The controller of clause 10, wherein the dormant state corresponds to a time period of reporting inactivity exceeding a predetermined time period.
12. The controller of clause 9, wherein the plurality of sensors are grouped into subsets of sensors, and wherein each subset of sensors is configured to monitor a predetermined coverage area.
13. The controller of clause 9, wherein each gateway device is assigned to a different coverage area.
14. The controller of clause 9, wherein the controller comprises a display interface configured to monitor and management sensor assignments.
15. The controller of clause 9, wherein the thermal management system is configured to be implemented in a data center.
16. A method for managing sensor assignments in a thermal management system, the method comprising steps performed by a controller including one or more processors, the method comprising: receiving self-identifying codes from a plurality of sensors in a sensor network; assigning the plurality of sensors to a gateway device assigned to a current sensor location in a coverage area; and upon moving a sensor to a new sensor location in the coverage area, reassigning a moved sensor to a new gateway device assigned to the new sensor location and disconnecting the moved sensor from a previously assigned gateway device.
17. The method of clause 16, the method further comprising: polling gateway devices to determine any sensors operating in a dormant state; and disconnecting any sensors determined to be operating in the dormant state from the gateway devices.
18. The method of clause 17, wherein the dormant state corresponds to a time period of reporting inactivity exceeding a predetermined time period.
19. The method of clause 16, wherein the controller comprises a display interface configured to monitor and manage sensor assignments.
20. The method of clause 16, wherein the thermal management system is implemented in a data center.
Disclosed herein are also the following items:
1. A system for monitoring a data center environment, the system comprising: a plurality of sensors configured to monitor environmental conditions in a data center; a plurality of gateway devices in communication with the plurality of sensors, the plurality of gateway devices configured to receive data from the plurality of sensors; and a controller in communication with the plurality of gateway devices, the controller including one or more processors configured to implement a sensor assignment scheme comprising: receiving a self-identifying code from each sensor; assigning each sensor to a gateway device corresponding to a current sensor location; and upon moving a sensor to a new location, reassigning a moved sensor to a different gateway device corresponding to the new sensor location and disconnecting the moved sensor from any previously assigned gateway device.
2. The system of item 1, wherein the sensor assignment scheme further comprises: polling the plurality of gateway devices to determine any sensors operating in a dormant state; and disconnecting any sensors determined to be operating in the dormant state from the plurality of gateway devices.
3. The system of item 2, wherein the dormant state corresponds to a time period of reporting inactivity exceeding a predetermined time period.
4. The system of any preceding item, wherein the plurality of sensors are grouped into subsets of sensors, and wherein each subset of sensors is configured to monitor a predetermined coverage area in the data center.
5. The system of any preceding item, wherein each gateway device is assigned to a different coverage area in the data center.
6. The system of any preceding item, wherein each sensor is assigned to one of the plurality of gateway devices based on a physical location in the data center.
7. The system of any preceding item, wherein the controller comprises a display interface configured to monitor and manage sensor assignments.
8. The system of any preceding item, wherein the system is configured to be implemented in conjunction with a cooling system in the data center.
9. A controller for controlling sensor assignments in a thermal management system including a plurality of sensors and a plurality of gateways devices, the controller including one or more processors configured to: receive a self-identifying code from each sensor; assign each sensor, based on a current sensor location, to a gateway device assigned to the current sensor location; and upon moving a sensor to a new location, reassigning a moved sensor to a different gateway device assigned to the new sensor location and disconnecting the moved sensor from a previously assigned gateway device.
10. The controller of item 9, further configured to: poll the plurality of gateway devices to determine any sensors operating in a dormant state; and disconnect any sensors determined to be operating in the dormant state from the plurality of gateway devices; and optionally, wherein the dormant state corresponds to a time period of reporting inactivity exceeding a predetermined time period.
11. The controller of item 9, wherein the plurality of sensors are grouped into subsets of sensors, and wherein each subset of sensors is configured to monitor a predetermined coverage area; and optionally, wherein each gateway device is assigned to a different coverage area; and optionally, wherein the controller comprises a display interface configured to monitor and management sensor assignments; and optionally, wherein the thermal management system is configured to be implemented in a data center.
12. A method for managing sensor assignments in a thermal management system, the method comprising steps performed by a controller including one or more processors, the method comprising: receiving self-identifying codes from a plurality of sensors in a sensor network; assigning the plurality of sensors to a gateway device assigned to a current sensor location in a coverage area; and upon moving a sensor to a new sensor location in the coverage area, reassigning a moved sensor to a new gateway device assigned to the new sensor location and disconnecting the moved sensor from a previously assigned gateway device.
13. The method of item 12, the method further comprising: polling gateway devices to determine any sensors operating in a dormant state; and disconnecting any sensors determined to be operating in the dormant state from the gateway devices.
14. The method of item 13, wherein the dormant state corresponds to a time period of reporting inactivity exceeding a predetermined time period.
15. The method of any one of the items 12 to 14, wherein the controller comprises a display interface configured to monitor and manage sensor assignments; and optionally, wherein the thermal management system is implemented in a data center.

## Claims

1. A system for monitoring a data center environment, the system comprising:
a plurality of sensors configured to monitor environmental conditions in a data center;
a plurality of gateway devices in communication with the plurality of sensors, the plurality of gateway devices configured to receive data from the plurality of sensors; and
a controller in communication with the plurality of gateway devices, the controller including one or more processors configured to implement a sensor assignment scheme comprising:
receiving a self-identifying code from each sensor;
assigning each sensor to a gateway device corresponding to a current sensor location; and
upon moving a sensor to a new location, reassigning a moved sensor to a different gateway device corresponding to the new sensor location and disconnecting the moved sensor from any previously assigned gateway device.

2. The system of claim 1, wherein the sensor assignment scheme further comprises:
polling the plurality of gateway devices to determine any sensors operating in a dormant state; and
disconnecting any sensors determined to be operating in the dormant state from the plurality of gateway devices.

3. The system of claim 2, wherein the dormant state corresponds to a time period of reporting inactivity exceeding a predetermined time period.

4. The system of any preceding claim, wherein the plurality of sensors are grouped into subsets of sensors, and wherein each subset of sensors is configured to monitor a predetermined coverage area in the data center.

5. The system of any preceding claim, wherein each gateway device is assigned to a different coverage area in the data center.

6. The system of any preceding claim, wherein each sensor is assigned to one of the plurality of gateway devices based on a physical location in the data center.

7. The system of any preceding claim, wherein the controller comprises a display interface configured to monitor and manage sensor assignments.

8. The system of any preceding claim, wherein the system is configured to be implemented in conjunction with a cooling system in the data center.

9. A controller for controlling sensor assignments in a thermal management system including a plurality of sensors and a plurality of gateways devices, the controller including one or more processors configured to:
receive a self-identifying code from each sensor;
assign each sensor, based on a current sensor location, to a gateway device assigned to the current sensor location; and
upon moving a sensor to a new location, reassigning a moved sensor to a different gateway device assigned to the new sensor location and disconnecting the moved sensor from a previously assigned gateway device.

10. The controller of claim 9, further configured to:
poll the plurality of gateway devices to determine any sensors operating in a dormant state; and
disconnect any sensors determined to be operating in the dormant state from the plurality of gateway devices;
and optionally, wherein the dormant state corresponds to a time period of reporting inactivity exceeding a predetermined time period.

11. The controller of claim 9, wherein the plurality of sensors are grouped into subsets of sensors, and wherein each subset of sensors is configured to monitor a predetermined coverage area;
and optionally, wherein each gateway device is assigned to a different coverage area;
and optionally, wherein the controller comprises a display interface configured to monitor and management sensor assignments;
and optionally, wherein the thermal management system is configured to be implemented in a data center.

12. A method for managing sensor assignments in a thermal management system, the method comprising steps performed by a controller including one or more processors, the method comprising:
receiving self-identifying codes from a plurality of sensors in a sensor network;
assigning the plurality of sensors to a gateway device assigned to a current sensor location in a coverage area; and
upon moving a sensor to a new sensor location in the coverage area, reassigning a moved sensor to a new gateway device assigned to the new sensor location and disconnecting the moved sensor from a previously assigned gateway device.

13. The method of claim 12, the method further comprising:
polling gateway devices to determine any sensors operating in a dormant state; and
disconnecting any sensors determined to be operating in the dormant state from the gateway devices.

14. The method of claim 13, wherein the dormant state corresponds to a time period of reporting inactivity exceeding a predetermined time period.

15. The method of any one of the claims 12 to 14, wherein the controller comprises a display interface configured to monitor and manage sensor assignments;
and optionally, wherein the thermal management system is implemented in a data center.
